# EUROPEAN PATENT APPLICATION

(11) **EP 4 813 568 A1**
(43) Date of publication of application: **30.09.2026**
(21) Application number: 24893937.3
(22) Date of filing: 25.10.2024
(51) Int. Cl.: B24B 9/00, B24B 21/00, B24B 49/12, H01L 21/304

(54) **SUBSTRATE PROCESSING DEVICE AND SUBSTRATE PROCESSING METHOD**

(30) Priority: 20.11.2023 JP 2023196699
(71) Applicant: EBARA CORPORATION, Ota-ku, Tokyo 144-8510 (JP)
(72) Inventor: KODERA, Kenji, Tokyo 144-8510 (JP); TAKENAKA, Hiroyuki, Tokyo 144-8510 (JP); SASAYA, Yusuke, Tokyo 144-8510 (JP); KITAMURA, Kei, Tokyo 144-8510 (JP)
(74) Representative: Wagner & Geyer
(86) International application number: PCT/JP2024/038133
(87) International publication number: WO 2025/109944

(57) **Abstract**

The present invention relates to a substrate processing apparatus and a substrate processing method for polishing a substrate, such as a wafer. The substrate processing apparatus includes: a polishing section (4) configured to polish a periphery of the substrate (W); a residual-film detector (9) configured to detect a residual film on the periphery of the substrate (W) polished by the polishing section (4); and a controller (20) configured to determine necessity of re-polishing of the periphery of the substrate (W) based on a detection result of the residual film by the residual-film detector (9), and determine a polishing condition for the re-polishing based on the detection result of the residual film when determining that the re-polishing is necessary. The polishing section (4) is configured to re-polish the periphery of the substrate (W) under the determined polishing condition.

## Description

### Technical Field

The present invention relates to a substrate processing apparatus and a substrate processing method for polishing a substrate, such as a wafer.

### Background Art

Management of a surface state of a substrate has recently attracted attention from the viewpoint of an increase in yield in manufacturing of semiconductor devices. In a semiconductor device manufacturing process, films of various materials are formed on a silicon wafer. Therefore, an unnecessary film or surface roughness may be formed on a periphery of the substrate. In recent years, it is a common practice to transport a substrate by holding only the periphery of the substrate with an arm. With such a background, the unnecessary film, remaining on the periphery of the substrate, may peel off during various processes and may adhere to devices formed on the substrate, and as a result, the yield may decrease. Thus, in order to remove the unnecessary film formed on the periphery of the substrate, polishing of the periphery of the substrate is performed using a polishing apparatus.

### Citation List

### Patent Literature

Patent document 1: Japanese laid-open patent publication No. 2013-160687
Patent document 2: Japanese laid-open patent publication No. 2008-537316

### Summary of Invention

### Technical Problem

However, a state of the unnecessary film formed on the periphery of the substrate varies from substrate to substrate. Therefore, if the periphery is polished according to a fixed polishing recipe regardless of the state of the film, the unnecessary film may not be completely removed from the periphery of the substrate. When the unnecessary film cannot be removed by polishing and a residual film is present, it is necessary to re-polish the periphery of the substrate.

Therefore, the present invention provides a substrate processing apparatus and a substrate processing method capable of appropriately determining a polishing condition for re-polishing based on a state of a residual film on a periphery of a substrate.

### Solution to Problem

In an embodiment, there is provided a substrate processing apparatus comprising: a polishing section configured to polish a periphery of a substrate; a residual-film detector configured to detect a residual film on the periphery of the substrate polished by the polishing section; and a controller configured to determine necessity of re-polishing of the periphery of the substrate based on a detection result of the residual film by the residual-film detector, and determine a polishing condition for the re-polishing based on the detection result of the residual film when determining that the re-polishing is necessary, wherein the polishing section is configured to re-polish the periphery of the substrate under the determined polishing condition.

In an embodiment, the residual-film detector includes: an imaging device configured to generate an image of the periphery of the substrate; and a detection processor configured to detect the residual film on the periphery of the substrate based on the image.

In an embodiment, the residual-film detector further includes a substrate holding device configured to hold the substrate and rotate the substrate, and the image is an image of an entire circumference of the periphery of the substrate.

In an embodiment, the detection processor is configured to calculate an area of the residual film from a hue appearing on the image, and the controller is configured to determine the necessity of the re-polishing of the periphery of the substrate based on a residual-film ratio which is a ratio of the area of the residual film in a target region in the image to an entire area of the target region.

In an embodiment, the controller is configured to determine a polishing time as the polishing condition based on the residual-film ratio and correlation data between residual-film ratio and polishing time.

In an embodiment, the residual-film detector is configured to detect the residual film in each of multiple regions of the periphery aligned in a thickness direction of the substrate, the controller is configured to: determine necessity of re-polishing in each of the multiple regions based on the detection result of the residual film; and determine, as the polishing condition for the re-polishing, a polishing angle corresponding to a region determined to require the re-polishing, and the multiple regions are regions polished by the polishing section at different polishing angles.

In an embodiment, the residual-film detector includes: multiple imaging devices respectively configured to generate images of the multiple regions; and a detection processor configured to detect the residual film in each of the multiple regions based on the images of the multiple regions.

In an embodiment, the residual-film detector includes: an imaging device configured to generate an image of the periphery of the substrate; and a detection processor configured to detect the residual film on the periphery of the substrate based on the image, and the controller has a polishing-condition determination model constructed by machine learning, and is configured to input the image into the polishing-condition determination model and output the polishing condition for the re-polishing from the polishing-condition determination model.

In an embodiment, there is provided a substrate processing method comprising:
detecting a residual film on a periphery of a substrate polished by a polishing section; determining necessity of re-polishing of the periphery of the substrate based on a detection result of the residual film; determining a polishing condition for the re-polishing based on the detection result of the residual film when determining that the re-polishing is necessary; and re-polishing the periphery of the substrate by the polishing section under the determined polishing condition.

In an embodiment, detecting the residual film on the periphery of the substrate comprises generating an image of the periphery of the substrate by an imaging device, and detecting the residual film on the periphery of the substrate based on the image.

In an embodiment, generating the image of the periphery of the substrate comprises generating an image of an entire circumference of the periphery of the substrate while the substrate is rotated by a substrate holding device.

In an embodiment, detecting the residual film on the periphery of the substrate comprises calculating an area of the residual film from a hue appearing on the image, and determining the necessity of the re-polishing of the periphery of the substrate comprises determining the necessity of the re-polishing of the periphery of the substrate based on a residual-film ratio which is a ratio of the area of the residual film in a target region in the image to an entire area of the target region.

In an embodiment, determining the polishing condition for the re-polishing comprises determining a polishing time as the polishing condition based on the residual-film ratio and correlation data between residual-film ratio and polishing time.

In an embodiment, detecting the residual film on the periphery of the substrate comprises detecting the residual film in each of multiple regions of the periphery aligned in a thickness direction of the substrate, determining the necessity of the re-polishing of the periphery of the substrate comprises determining necessity of re-polishing in each of the multiple regions based on the detection result of the residual film, determining the polishing condition for the re-polishing includes determining, as the polishing condition for the re-polishing, a polishing angle corresponding to a region determined to require the re-polishing, and the multiple regions are regions polished by the polishing section at different polishing angles.

In an embodiment, detecting the residual film on the periphery of the substrate comprises generating an image of the periphery of the substrate by an imaging device, and detecting the residual film on the periphery of the substrate based on the image, and determining the polishing condition for the re-polishing comprises inputting the image into a polishing-condition determination model constructed by machine learning, and outputting the polishing condition for the re-polishing from the polishing-condition determination model.

### Advantageous Effects of Invention

The controller determines the necessity of the re-polishing based on the detection result of the residual film on the periphery of the substrate, and determines the polishing condition for the re-polishing based on the detection result of the residual film on the periphery of the substrate when determining that the re-polishing is necessary. Therefore, the polishing condition for the re-polishing suitable for a state of the residual film on the periphery of the substrate can be determined.

### Brief Description of Drawings

[FIG. 1] FIG. 1 is a plan view showing an embodiment of a substrate processing apparatus;
[FIG. 2A] FIG. 2A is an enlarged cross-sectional view showing a periphery of a substrate;
[FIG. 2B] FIG. 2B is an enlarged cross-sectional view showing a periphery of a substrate;
[FIG. 3] FIG. 3 is a plan view showing an embodiment of a polishing module;
[FIG. 4] FIG. 4 is a side view of the polishing module shown in FIG. 3;
[FIG. 5] FIG. 5 is a diagram showing a manner in which a polishing head is polishing a bevel portion of the substrate;
[FIG. 6] FIG. 6 is a diagram showing a manner in which the polishing head is polishing a top-edge portion of the substrate;
[FIG. 7] FIG. 7 is a diagram showing a manner in which the polishing head is polishing a bottom-edge portion of the substrate;
[FIG. 8] FIG. 8 is a schematic diagram showing an embodiment of a residual-film detector;
[FIG. 9] FIG. 9 is an enlarged schematic diagram of imaging devices shown in FIG. 8;
[FIG. 10] FIG. 10 is a diagram showing an example of images of multiple regions of the periphery of the substrate respectively generated by the imaging devices;
[FIG. 11] FIG. 11 is a diagram showing an example of an image of an entire circumference of the periphery of the substrate;
[FIG. 12] FIG. 12 is a flowchart showing an embodiment of a substrate processing method;
[FIG. 13] FIG. 13 is a schematic diagram showing an embodiment of a controller having a polishing-condition determination model and the residual-film detector; and
[FIG. 14] FIG. 14 is a schematic diagram showing an example of the polishing-condition determination model constructed using a deep learning method.

### Description of Embodiments

Hereinafter, embodiments of the present invention will be described with reference to the drawings.

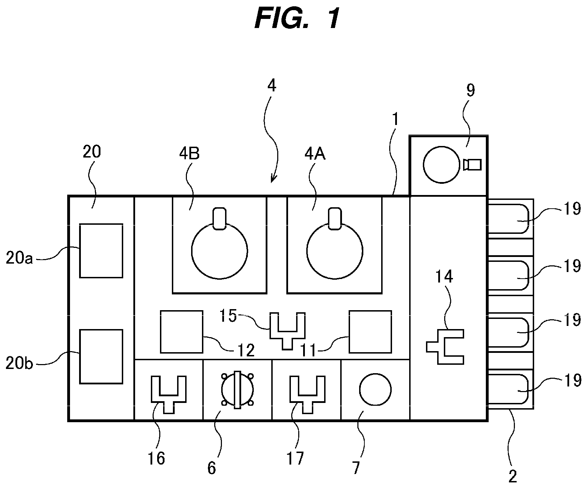

FIG. 1 is a plan view showing an embodiment of a substrate processing apparatus. The substrate processing apparatus includes a housing 1, a load port 2, a polishing section 4 having two polishing modules 4A and 4B, a cleaning section 6, a drying section 7, a residual-film detector 9, a first temporary station 11, a second temporary station 12, a first transfer robot 14, a second transfer robot 15, a third transfer robot 16, a fourth transfer robot 17, and a controller 20. The polishing modules 4A and 4B, the cleaning section 6, the drying section 7, the residual-film detector 9, the first temporary station 11, the second temporary station 12, the first transfer robot 14, the second transfer robot 15, the third transfer robot 16, the fourth transfer robot 17, and the controller 20 are arranged in the housing 1.

Polishing-target substrates, such as wafers, are housed in substrate cassettes 19, and the substrate cassettes 19 are placed on the load port 2. The first transfer robot 14 is arranged adjacent to the load port 2. The first transfer robot 14 is configured to remove a substrate to be polished from the substrate cassette 19 on the load port 2, and place the substrate on the first temporary station 11. The first temporary station 11 is a temporary station on which the substrate is temporarily placed before the substrate is polished by the polishing modules 4A and 4B.

The polishing section 4 including the two polishing modules 4A and 4B is configured to polish a periphery of a substrate, such as a wafer. In this embodiment, the polishing section 4 includes the two polishing modules 4A and 4B, while in one embodiment, the polishing section 4 may include one polishing module, or three or more polishing modules. In this embodiment, the periphery of the substrate is polished by at least one of the polishing module 4A and the polishing module 4B.

The second transfer robot 15 is arranged adjacent to the polishing module 4A and the polishing module 4B. The second transfer robot 15 is configured to transport the substrate placed on the first temporary station 11 to the polishing module 4A or the polishing module 4B. Further, the second transfer robot 15 is configured to remove the substrate from the polishing module 4A or the polishing module 4B, and place the substrate on the second temporary station 12. The second temporary station 12 is a temporary station on which the substrate is temporarily placed before the substrate polished by the polishing module 4A or the polishing module 4B is cleaned by the cleaning section 6.

The third transfer robot 16 is arranged adjacent to the cleaning section 6. The third transfer robot 16 is configured to transport the substrate placed on the second temporary station 12 to the cleaning section 6. The cleaning section 6 of this embodiment is configured to clean the substrate by a roll-shaped sponge member. In one embodiment, the cleaning section 6 may be configured to clean the substrate by a pencil-shaped sponge member. In another embodiment, the substrate processing apparatus may include a cleaning section configured to clean the substrate by a pencil-shaped sponge member in addition to the cleaning section 6 configured to clean the substrate by the roll-shaped sponge member.

The fourth transfer robot 17 is arranged between the cleaning section 6 and the drying section 7. The fourth transfer robot 17 is configured to remove the substrate from the cleaning section 6, and transport the substrate to the drying section 7. The drying section 7 is configured to dry the substrate cleaned by the cleaning section 6. The first transfer robot 14 is configured to transport the substrate between the drying section 7 and the residual-film detector 9. The substrate dried by the drying section 7 is transported to the residual-film detector 9 by the first transfer robot 14.

The residual-film detector 9 is configured to detect a residual film on the periphery of the substrate polished by the polishing module 4A and/or the polishing module 4B, cleaned by the cleaning section 5, and dried by the drying section 7. As will be described later, the controller 20 is configured to determine a necessity of re-polishing of the periphery of the substrate based on a detection result of the residual film by the residual-film detector 9.

When the controller 20 determines that the re-polishing of the periphery of the substrate is necessary, the first transfer robot 14 is configured to remove the substrate from the residual-film detector 9, and transport the substrate to the polishing module 4A or the polishing module 4B. The polishing module 4A or the polishing module 4B re-polishes the periphery of the substrate. When the controller 20 determines that the re-polishing of the periphery of the substrate is unnecessary, the first transfer robot 14 is configured to remove the substrate from the residual-film detector 9, and return the substrate to the substrate cassette 19 of the load port 2.

The polishing section 4 (including the polishing module 4A and the polishing module 4B), the cleaning section 6, the drying section 7, the residual-film detector 9, the first transfer robot 14, the second transfer robot 15, the third transfer robot 16, and the fourth transfer robot 17 are electrically coupled to the controller 20. Operations of the polishing section 4, the cleaning section 6, the drying section 7, the residual-film detector 9, the first transfer robot 14, the second transfer robot 15, the third transfer robot 16, and the fourth transfer robot 17 are controlled by the controller 20.

The controller 20 includes at least one computer. The controller 20 includes a memory 20a storing programs and the like therein, and an arithmetic device 20b configured to perform arithmetic operations according to instructions contained in the programs. The memory 20a includes a main memory, such as a random access memory (RAM), and an auxiliary memory, such as a hard disk drive (HDD) or a solid state drive (SSD). Examples of the arithmetic device 20b include a CPU (central processing unit) and a GPU (graphics processing unit). However, the specific configuration of the controller 20 is not limited to these examples.

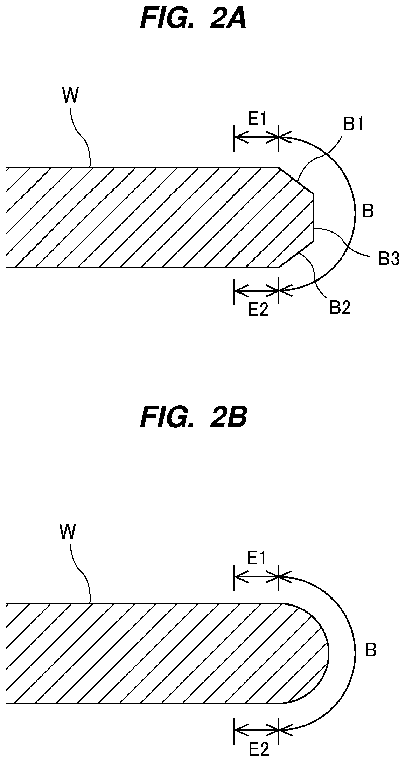

Next, details of the polishing modules 4A and 4B of the polishing section 4 will be described. The polishing modules 4A and 4B are configured to polish the periphery of the substrate W. FIG. 2A and FIG. 2B are enlarged cross-sectional views each showing the periphery of the substrate W. More specifically, FIG. 2A is a cross-sectional view of a so-called straight type substrate, and FIG. 2B is a cross-sectional view of a so-called round type substrate. A bevel portion B has a beveled shape or a rounded shape.

In the substrate W of FIG. 2A, the bevel portion B is an outermost peripheral surface of the substrate W constituted of an upper slope surface (or an upper bevel portion) B1, a lower slope surface (or a lower bevel portion) B2, and a side portion (or an apex) B3. In the substrate W of FIG. 2B, the bevel portion B is a portion constituting an outermost peripheral surface of the substrate W and having a curved cross section. A top-edge portion E1 is an annular flat portion located radially inwardly of the bevel portion B. A bottom-edge portion E2 is an annular flat portion located at an opposite side from the top-edge portion E1 and located radially inwardly of the bevel portion B. The top-edge portion E1 may include a region in which devices are formed. In this specification, the periphery of the substrate W indicates a region including at least one of the top-edge portion E1, the bevel portion B, and the bottom-edge portion E2.

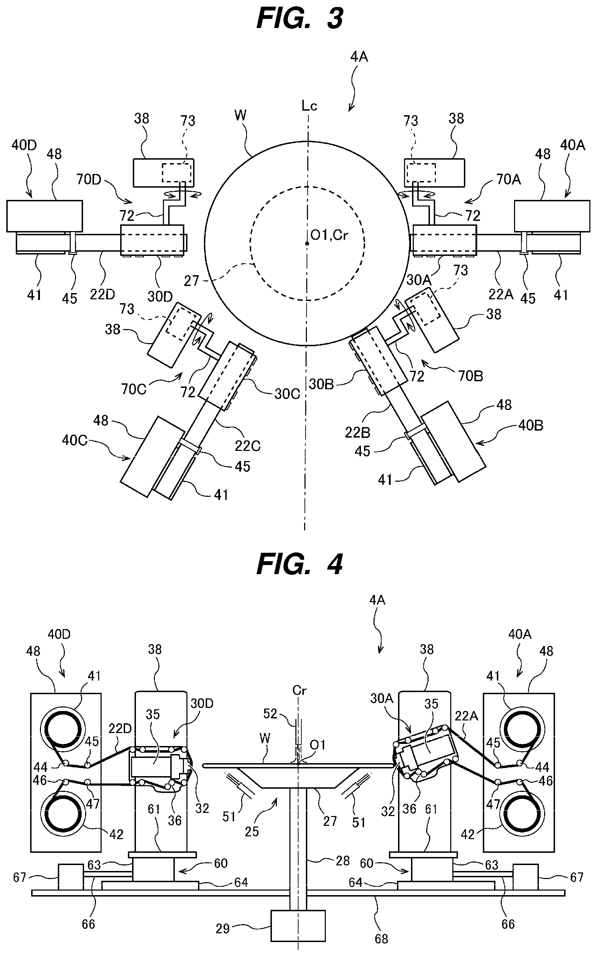

FIG. 3 is a plan view showing an embodiment of the polishing module 4A, and FIG. 4 is a side view of the polishing module 4A shown in FIG. 3. Since the polishing module 4A and the polishing module 4B have basically the same configuration, the polishing module 4A will be described below. The polishing module 4A includes a substrate holder 25, four polishing heads 30A to 30D, four polishing-tape feeding mechanisms 40A to 40D, lower supply nozzles 51, and an upper supply nozzle 52. In FIG. 4, depiction of the polishing heads 30B, 30C is omitted.

The substrate holder 25 includes a holding stage 27 configured to hold the substrate W by vacuum suction, a shaft 28 coupled to a center portion of the holding stage 27, and a holding-stage driving mechanism 29 configured to rotate and vertically move the holding stage 27. The shaft 28 of the substrate holder 25 extends through a base plate 68, and the holding-stage driving mechanism 29 is arranged below the base plate 68. The holding-stage driving mechanism 29 is configured to rotate the holding stage 27 about a rotation axis Cr, and is configured to move the holding stage 27 in a vertical direction along the rotation axis Cr. An axis passing through the center O1 of the substrate W coincides with the rotation axis Cr of the holding stage 27.

The polishing module 4A includes at least one polishing head for polishing the periphery of the substrate W. In this embodiment, as shown in FIG. 3, the four polishing heads 30A, 30B, 30C, and 30D are arranged radially outwardly of the substrate W held by the substrate holder 25. In this embodiment, the four polishing-tape feeding mechanisms 40A, 40B, 40C, and 40D are provided radially outwardly of the four polishing heads 30A, 30B, 30C, and 30D, respectively. In one embodiment, the number of polishing heads and the number of polishing-tape feeding mechanisms corresponding to the polishing heads may be three or less, or five or more.

As shown in FIG. 3, the polishing head 30A and the polishing head 30D are arranged symmetrically with respect to a line Lc passing through the center O1 of the substrate W and being orthogonal to the rotation axis Cr. The polishing head 10B and the polishing head 10C are arranged symmetrically with respect to the line Lc. However, arrangement of the first polishing head 10A, the second polishing head 10B, the third polishing head 10C, and the fourth polishing head 10D is not limited to this embodiment.

The polishing head 30A is configured to press a polishing tape 22A fed from the polishing-tape feeding mechanism 40A against the periphery of the substrate W to polish the periphery of the substrate W. The polishing head 30B is configured to press a polishing tape 22B fed from the polishing-tape feeding mechanism 40B against the periphery of the substrate W to polish the periphery of the substrate W. The polishing head 30C is configured to press a polishing tape 22C fed from the polishing-tape feeding mechanism 40C against the periphery of the substrate W to polish the periphery of the substrate W. The polishing head 30D is configured to press a polishing tape 22D fed from the polishing-tape feeding mechanism 40D against the periphery of the substrate W to polish the periphery of the substrate W.

The polishing heads 30A, 30B, 30C, and 30D have basically the same configuration, and the polishing-tape feeding mechanisms 40A, 40B, 40C, and 40D have basically the same configuration. The polishing head 30A and the polishing-tape feeding mechanism 40A will be described below.

As shown in FIG. 4, the polishing head 30A includes a pressing member 32 configured to press a polishing surface of the polishing tape 22A against the periphery of the substrate W, and an air cylinder 35 as an actuator configured to move the pressing member 32 toward the periphery of the substrate W. A pressing force on the polishing tape 22A against the substrate W is regulated by controlling an air pressure supplied to the air cylinder 35. The pressing member 32 is arranged at a back surface side (at a side opposite from the polishing surface having abrasive grains) of the polishing tape 22A. When the air cylinder 35 moves the pressing member 32 toward the substrate W, the pressing member 32 presses the polishing tape 22A against the periphery of the substrate W from the back side of the polishing tape 22A. In this manner, the polishing head 30A polishes the periphery of the substrate W with the polishing tape 22A.

The polishing-tape feeding mechanism 40A is configured to feed the polishing tape 22A to the polishing head 30A and collect the polishing tape 22A from the polishing head 30A. The polishing-tape feeding mechanism 40A includes a tape feeding reel 41, a tape take-up reel 42, and multiple guide rollers 44, 45, 46, and 47. The tape feeding reel 41, the tape take-up reel 42 and the multiple guide rollers 44, 45, 46, and 47 are fixed to a reel base 48. The polishing tape 22A is fed to the polishing head 30A such that the polishing surface of the polishing tape 22A faces the periphery of the substrate W. An advancing direction of the polishing tape 22A is guided by the guide rollers 44, 45, 46, and 47. The polishing tape 22A fed to the polishing head 30A is advanced at a predetermined speed by a tape advancing mechanism 36 provided in the polishing head 30A.

Not-shown tension motors are coupled to the tape feeding reel 41 and the tape take-up reel 42, respectively. The tape feeding reel 41 and the tape take-up reel 42 are fixed to the reel base 48 via the tension motors. The tension motors are configured to apply predetermined torque(s) to the tape feeding reel 41 and the tape take-up reel 42, so that a predetermined tension can be applied to the polishing tape 22A.

The lower supply nozzles 51 are configured to supply liquid onto a lower surface of the substrate W. The upper supply nozzle 52 is configured to supply liquid onto an upper surface of the substrate W. An example of the liquid supplied from the lower supply nozzles 51 and the upper supply nozzle 52 to the substrate W is pure water. During polishing of the substrate W, the liquid is supplied from the lower supply nozzles 51 onto the lower surface of the substrate W, and the liquid is supplied from the upper supply nozzle 52 onto the upper surface of the substrate W.

The polishing module 4A further includes four polishing-head translation mechanisms 60 configured to translate the polishing heads 30A, 30B, 30C, and 30D along a radial direction of the substrate W, respectively. Each of the polishing-head translation mechanisms 60 includes a coupling member 63, a guide rail 64, a coupling shaft 66, and an air cylinder 67 as an actuator. Since the four polishing-head translation mechanisms 60 have basically the same configuration, the polishing-head translation mechanism 60 for translating the polishing head 30A will be described below.

The polishing-head translation mechanism 60 is coupled to the polishing head 30A via a movable plate 61. More specifically, a polishing-head supporting member 38 coupled to the polishing head 30A is fixed to an upper surface of the movable plate 61, and the polishing-head translation mechanism 60 is coupled to a lower surface of the movable plate 61. The polishing head 30A is movable together with the movable plate 61.

The guide rail 64 extends in a radial direction of the holding stage 27, and is fixed to an upper surface of the base plate 68. The air cylinder 67 is coupled to the movable plate 61 via the coupling member 63 and the coupling shaft 66, and is fixed to the upper surface of the base plate 68. The polishing-head translation mechanism 60 can move the polishing head 30A in a direction approaching the rotation axis Cr of the substrate W (i.e., the center O1 of the substrate W) and in a direction away from the rotation axis Cr (i.e., the center O1 of the substrate W) at a predetermined moving speed by driving the air cylinder 67 to move the movable plate 61 along the guide rail 64.

The specific configuration of the polishing-head translation mechanism 60 is not limited to this embodiment as long as the polishing head 30A can be moved in the direction approaching the rotation axis Cr of the substrate W (i.e., the center O1 of the substrate W) and in the direction away from the rotation axis Cr (i.e., the center O1 of the substrate W).

As shown in FIG. 3, the polishing module 4A further includes four polishing-head tilting mechanisms 70A, 70B, 70C, and 70D configured to tilt the polishing heads 30A, 30B, 30C, and 30D with respect to a substrate holding surface of the holding stage 27, respectively. The polishing-head tilting mechanism 70A is coupled to the polishing head 30A, the polishing-head tilting mechanism 70B is coupled to the polishing head 30B, the polishing-head tilting mechanism 70C is coupled to the polishing head 30C, and the polishing-head tilting mechanism 70D is coupled to the polishing head 30D. Since the four polishing-head tilting mechanisms 70A to 70D have basically the same configuration, the polishing-head tilting mechanism 70A will be described below.

The polishing-head tilting mechanism 70A includes a crank arm 72 coupled to the polishing head 30A, and an arm rotating device 73 configured to rotate the crank arm 72. One end of the crank arm 72 is located at the same height as the substrate holding surface of the holding stage 27, and is coupled to the arm rotating device 73. The other end of the crank arm 72 is coupled to the polishing head 30A. The arm rotating device 73 is arranged in the polishing-head supporting member 38.

When the arm rotating device 73 rotates the crank arm 72, the polishing-head tilting mechanism 70A can tilt the entire polishing head 30A with respect to the substrate W on the substrate holding surface of the holding stage 27 at a predetermined tilting speed. Further, the polishing-head tilting mechanism 70A is configured to maintain a predetermined tilt angle of the polishing head 30A. The specific configuration of the polishing-head tilting mechanism 70A is not limited to this embodiment as long as the polishing head 30A can be tilted with respect to the substrate holding surface of the holding stage 27 and the substrate W.

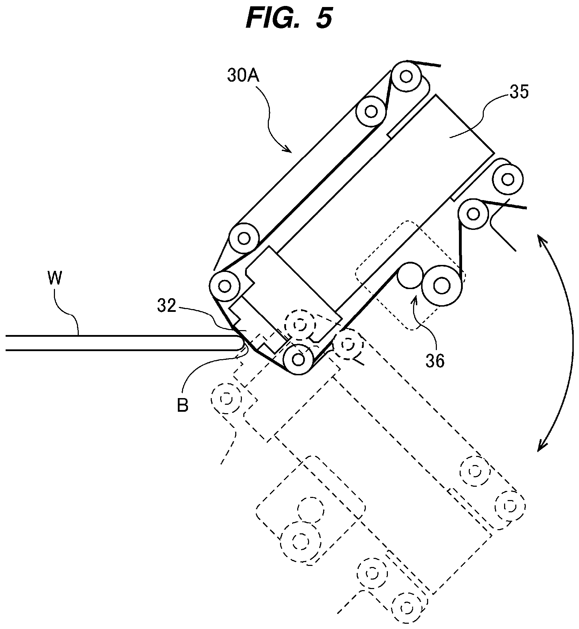

FIG. 5 is a diagram showing a manner in which the polishing head 30A is polishing the bevel portion B of the substrate W. As shown in FIG. 5, the polishing head 30A can polish the bevel portion B of the substrate W while the tilt angle of the polishing head 30A is continuously changed by the polishing-head tilting mechanism 70A (see FIG. 3). Alternatively, the polishing head 30A can polish a specific region of the bevel portion B of the substrate W (e.g., the upper slope surface (or the upper bevel portion) B1, the lower slope surface (or the lower bevel portion) B2, and the side portion (or the apex) B3 described with reference to FIG. 2A), with the tilt angle of the polishing head 30A fixed by the polishing-head tilting mechanism 70A. For example, the polishing-head tilting mechanism 70A tilts the polishing head 30A to a polishing angle corresponding to the upper slope surface (or the upper bevel portion) B1, so that the polishing head 30A can polish the upper slope surface (or the upper bevel portion) B1.

Similarly, the polishing heads 30B, 30C, and 30D can polish the bevel portion B of the substrate W while the polishing-head tilting mechanisms 70B, 70C, and 70D continuously change the tilt angles of the polishing heads 30B, 30C, and 30D, respectively. Alternatively, the polishing heads 30B, 30C, and 30D can polish the bevel portion B of the substrate W, with the tilt angles of the polishing heads 30B, 30C, and 30D fixed by the polishing-head tilting mechanisms 70B, 70C, and 70D, respectively.

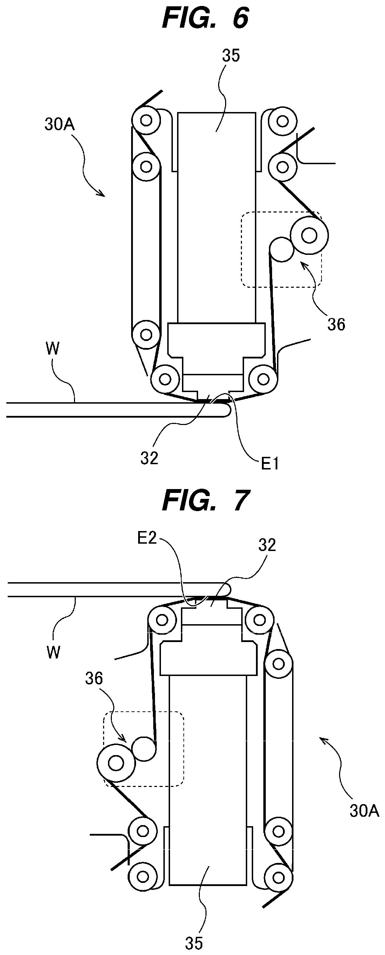

FIG. 6 is a diagram showing a manner in which the polishing head 30A is polishing the top-edge portion E1 of the substrate W, and FIG. 7 is a diagram showing a manner in which the polishing head 30A is polishing the bottom-edge portion E2 of the substrate W. As shown in FIG. 6, the polishing-head tilting mechanism 70A (see FIG. 3) tilts the polishing head 30A such that the pressing member 32 of the polishing head 30A faces the top-edge portion E1 of the substrate W, so that the polishing head 30A can polish the top-edge portion E1 of the substrate W. Further, as shown in FIG. 7, the polishing-head tilting mechanism 70A (see FIG. 3) tilts the polishing head 30A such that the pressing member 32 of the polishing head 30A faces the bottom-edge portion E2 of the substrate W, so that the polishing head 30A can polish the bottom-edge portion E2 of the substrate W.

Similarly, the polishing-head tilting mechanisms 70B, 70C, and 70D tilt the polishing heads 30B, 30C, and 30D, respectively, such that the polishing heads 30B, 30C, and 30D face the top-edge portion E1 and the bottom-edge portion E2 of the substrate W, so that the polishing heads 30B, 30C, and 30D can polish the top-edge portion E1 and the bottom-edge portion E2 of the substrate W. In this manner, the polishing heads 30A to 30D can polish multiple regions of the periphery of the substrate W (i.e., the bevel portion B, the top-edge portion E1, and the bottom-edge portion E2).

The polishing heads 30A to 30D can simultaneously polish the periphery of the substrate W. For example, in order to improve a polishing rate, the polishing head 30A may polish the entire periphery of the substrate W including the top-edge portion E1, the bevel portion B, and the bottom-edge portion E2, and simultaneously, the polishing head 30B may polish the entire periphery of the substrate W including the top-edge portion E1, a bevel portion B2, and the bottom-edge portion E2. Alternatively, the polishing head 30A may polish the top-edge portion E1, the polishing head 30B may polish the bevel portion B, and the polishing head 30C may polish the bottom-edge portion E2.

The polishing tapes 22A to 22D may be different types of polishing tapes. For example, a polishing tape for rough-polishing (i.e., a polishing tape having larger abrasive grains) may be used as the polishing tape 22A, and polishing tapes for finish-polishing (i.e., polishing tapes having smaller abrasive grains) may be used as the polishing tapes 22B to 22D. In this case, the polishing head 30A may rough-polish the entire periphery of the substrate W including the top-edge portion E1, the bevel portion B, and the bottom-edge portion E2, and thereafter, the polishing head 30B may finish-polish the top-edge portion E1, the polishing head 30C may finish-polish the bevel portion B, and the polishing head 30D may finish-polish the entire periphery of the substrate W including the bottom-edge portion E2.

The substrate holder 25, the polishing heads 30A to 30D, the polishing-tape feeding mechanisms 40A to 40D, the lower supply nozzles 51, the upper supply nozzle 52, the polishing-head translation mechanisms 60, and the polishing-head tilting mechanisms 70A to 70D are electrically coupled to the controller 20 (see FIG. 1). Operations of the substrate holder 25, the polishing heads 30A to 30D, the polishing-tape feeding mechanisms 40A to 40D, the lower supply nozzle 51, the upper supply nozzle 52, the polishing-head translation mechanisms 60, and the polishing-head tilting mechanisms 70A to 70D are controlled by the controller 20.

Polishing of the periphery of the substrate W is performed as follows. A case in which the polishing head 30A of the polishing module 4A polishes the periphery of the substrate W will be described below. When the substrate W is transported to the polishing module 4A, the controller 20 instructs the holding-stage driving mechanism 29 of the substrate holder 25 to elevate the holding stage 27. The substrate W is placed on the substrate holding surface of the holding stage 27, and is held by the holding stage 27 by vacuum suction. The controller 20 instructs the holding-stage driving mechanism 29 of the substrate holder 25 to lower the substrate W to a polishing position, and to rotate the holding stage 27 and the substrate W. Further, the controller 20 instructs the lower supply nozzles 51 and the upper supply nozzle 52 to supply the liquid from the lower supply nozzles 51 and the upper supply nozzle 52.

Next, the controller 20 instructs the polishing-tape feeding mechanism 40A to start feeding the polishing tape 22A to the polishing head 30A. When the top-edge portion E1 of the substrate W is polished, the controller 20 instructs the polishing-head tilting mechanism 70A to tilt the polishing head 30A to a polishing angle corresponding to the top-edge portion E1. The controller 20 then instructs the polishing-head translation mechanism 60 to move the polishing head 30A. The controller 20 instructs the air cylinder 35 of the polishing head 30A to press the polishing tape 22A against the top-edge portion E1 of the substrate W by the pressing member 32 of the polishing head 30A to polish the top-edge portion E1. The bottom-edge portion E2 of the substrate W is also polished in the same manner.

When the bevel portion B of the substrate W is polished continuously, the controller 20 instructs the polishing-head tilting mechanism 70A to tilt the polishing head 30A to a polishing angle corresponding to a portion where the polishing of the bevel portion B is started. Thereafter, the controller 20 instructs the air cylinder 35 of the polishing head 30A to press the polishing tape 22A against the periphery of the substrate W with the pressing member 32, while the polishing head 30A is tilted in a predetermined angle range.

When a specific region of the bevel portion B of the substrate W (e.g., the upper bevel portion B1) is polished, the controller 20 instructs the polishing-head tilting mechanism 70A to tilt the polishing head 30A to a polishing angle corresponding to the specific region of the bevel portion B (e.g., the upper bevel portion B1). The controller 20 then instructs the air cylinder 35 of the polishing head 30A to press the polishing tape 22A against the specific region of the substrate W with the pressing member 32 of the polishing head 30A.

After the periphery of the substrate W is polished according to a predetermined polishing recipe, the controller 20 instructs each component of the polishing module 4A to terminate the polishing of the substrate W. Specifically, the controller 20 causes the polishing-head translation mechanism 60 or the polishing-head tilting mechanism 70A to stop operating, and causes the air cylinder 35 of the polishing head 30A to stop driving to move the pressing member 32 of the polishing head 30A away from the substrate W. The controller 20 then causes the substrate holder 25, the polishing-tape feeding mechanism 40A, the polishing-tape feeding mechanism 40B, the lower supply nozzles 51, and the upper supply nozzle 52 to stop operating to terminate the polishing of the substrate W.

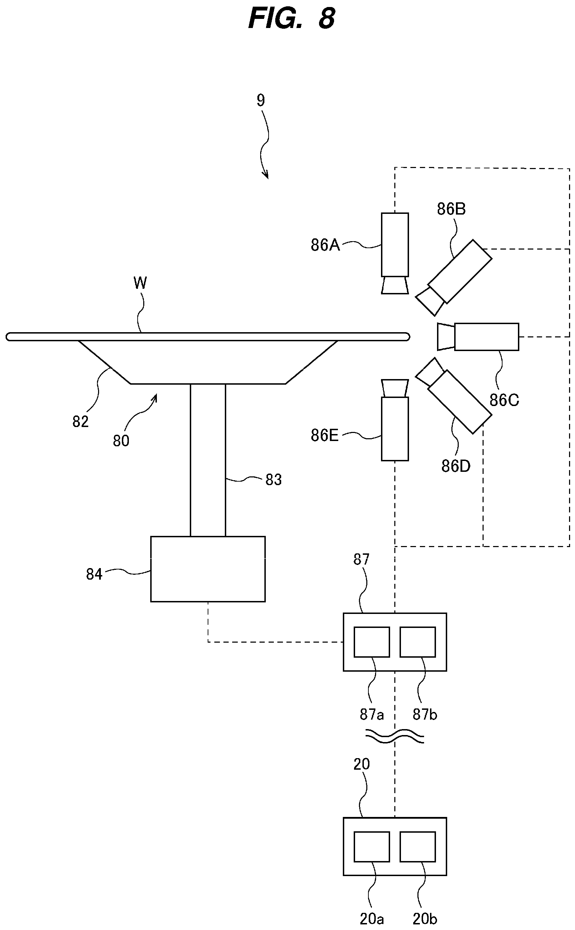

Next, details of the residual-film detector 9 will be described. FIG. 8 is a schematic diagram showing an embodiment of the residual-film detector. If an unnecessary film cannot be removed by polishing of the periphery of the substrate W by the polishing module 4A or 4B, the residual film may be present on the periphery of the substrate W. The residual-film detector 9 is configured to detect the residual film on the periphery of the substrate W polished by the polishing module 4A or 4B. As shown in FIG. 8, the residual-film detector 9 of this embodiment includes a substrate holding device 80 configured to hold and rotate the substrate W, at least one imaging device (in this embodiment, five imaging devices 86A, 86B, 86C, 86D, and 86E) configured to generate an image of the periphery of the substrate W, and a detection processor 87 configured to detect the residual film on the periphery of the substrate W based on the image generated by the imaging devices 86A to 86E.

The substrate holding device 80 includes a holding stage 82 configured to hold the substrate W by vacuum suction, a shaft 83 coupled to a center portion of the holding stage 82, and a holding-stage rotating mechanism 84 configured to rotate the holding stage 82. The holding-stage rotating mechanism 84 is configured to rotate the holding stage 82 about an axis of the shaft 83.

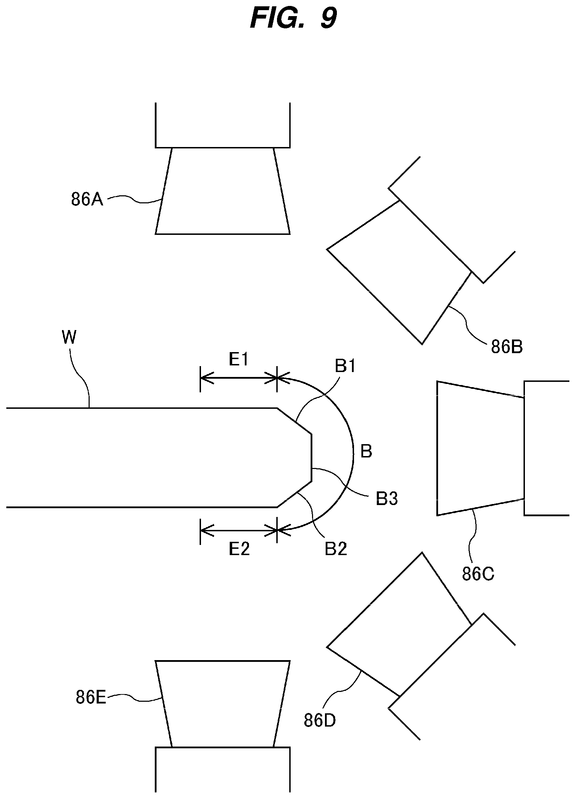

FIG. 9 is an enlarged schematic diagram of the imaging devices 86A to 86E shown in FIG. 8. The five imaging devices 86A to 86E are configured to respectively generate images of multiple (five in this embodiment) regions of the periphery of the substrate W aligned in a thickness direction of the substrate W. In this embodiment, the substrate W is the straight type substrate described with reference to FIG. 2A, and the multiple regions of the periphery of the substrate W are the top-edge portion E1, the upper slope surface (or the upper bevel portion) B1, the side portion (or the apex) B3, the lower slope surface (or the lower bevel portion) B2, and the bottom-edge portion E2. The multiple regions of the periphery of the substrate W are regions polished at different polishing angles by the polishing modules 4A and 4B of the polishing section 4.

The imaging device 86A is arranged to face the top-edge portion E1 of the substrate W, and is configured to generate an image including the top-edge portion E1 of the substrate W. The imaging device 86B is arranged to face the upper slope surface (or the upper bevel portion) B1 of the substrate W, and is configured to generate an image including the upper slope surface (or the upper bevel portion) B1 of the substrate W. The imaging device 86C is arranged to face the side portion (or the apex) B3 of the substrate W, and is configured to generate an image including the side portion (or the apex) B3 of the substrate W. The imaging device 86D is arranged to face the lower slope surface (or the lower bevel portion) B2 of the substrate W, and is configured to generate an image including the lower slope surface (or the lower bevel portion) B2 of the substrate W. The imaging device 86E is arranged to face the bottom-edge portion E2 of the substrate W, and is configured to generate an image including the bottom-edge portion E2 of the substrate W.

An example of the imaging devices 86A to 86E is a camera having an image sensor, such as a CCD sensor or a CMOS sensor. In this embodiment, the imaging devices 86A to 86E are configured to generate color images of the periphery of the substrate W. In one embodiment, the imaging devices 86A to 86E may be configured to generate grayscale images of the periphery of the substrate W.

In this embodiment, the residual-film detector 9 includes the five imaging devices 86A to 86E, while the number of imaging devices is not particularly limited to this embodiment. For example, the residual-film detector 9 may include a single imaging device, and may be configured to generate an image of a part or all of the regions of the periphery of the substrate W by the single imaging device.

In this embodiment, the substrate holding device 80 and the imaging devices 86A to 86E are electrically coupled to the detection processor 87, and operations of the substrate holding device 80 and the imaging devices 86A to 86E are controlled by the detection processor 87. In one embodiment, the substrate holding device 80 and the imaging devices 86A to 86E may be electrically coupled to the controller 20, and operations of the substrate holding device 80 and the imaging devices 86A to 86E may be controlled by the controller 20.

The detection processor 87 includes at least one computer. The detection processor 87 includes a memory 87a storing programs and the like therein, and an arithmetic device 87b configured to perform arithmetic operations according to instructions contained in the programs. The memory 87a includes a main memory, such as a random access memory (RAM), and an auxiliary memory, such as a hard disk drive (HDD) or a solid state drive (SSD). Examples of the arithmetic device 87b include a CPU (central processing unit) and a GPU (graphics processing unit). However, the specific configuration of the detection processor 87 is not limited to these examples. In one embodiment, the detection processor 87 may be configured integrally with the controller 20.

The detection processor 87 instructs the holding-stage rotating mechanism 84 of the substrate holding device 80 to rotate the holding stage 82 and the substrate W, and causes the imaging devices 86A to 86E to generate images of the periphery of the substrate W every time the substrate W rotates by a predetermined angle. The detection processor 87 obtains an image of an entire circumference of the periphery of the substrate W generated by the imaging devices 86A to 86E while the substrate W makes one revolution. The image of the entire circumference of the periphery of the substrate W is constituted of multiple images of the periphery of the substrate W arranged in a circumferential direction of the substrate W. For example, every time the substrate W rotates 1.5°, the detection processor 87 instructs the imaging devices 86A to 86E to generate the images of the periphery of the substrate W. Each of the imaging devices 86A to 86E generates 240 images (360°/1.5°=240 images), which are the image of the entire circumference of the corresponding region of the periphery of the substrate W arranged in the circumferential direction of the substrate W while the substrate W makes one revolution.

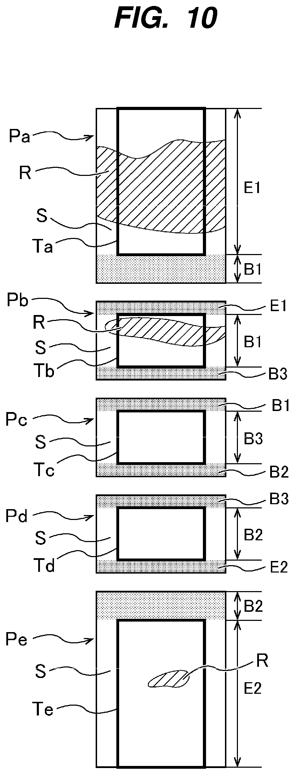

FIG. 10 is a diagram showing an example of images Pa, Pb, Pc, Pd, and Pe of the multiple regions of the periphery of the substrate W respectively generated by the imaging devices 86A, 86B, 86C, 86D, and 86E. The images Pa to Pe shown in FIG. 10 are images generated by the imaging devices 86A to 86E in a single imaging operation, respectively. The image Pa is an image including the top-edge portion E1 of the substrate W generated by the imaging device 86A. The image Pb is an image including the upper slope surface (or the upper bevel portion) B1 of the substrate W generated by the imaging device 86B. The image Pc is an image including the side portion (or the apex) B3 of the substrate W generated by the imaging device 86C. The image Pd is an image including the lower slope surface (or the lower bevel portion) B2 of the substrate W generated by the imaging device 86D. The image Pe is an image including the bottom-edge portion E2 of the substrate W generated by the imaging device 86E.

Portions of the substrate W having different inclinations have different hues appearing on the images. In the images shown in FIG. 10, for example, the image Pa includes the top-edge portion E1 and a part of the upper slope surface (or the upper bevel portion) B1, so that the top-edge portion E1 and the upper slope surface (or the upper bevel portion) B1 appear in different hues. The image Pe includes the bottom-edge portion E2 and a part of the lower slope surface (or the lower bevel portion) B2, so that the lower slope surface (or the lower bevel portion) B2 and the bottom-edge portion E2 appear in different hues.

Furthermore, a portion S where the unnecessary film has been removed by the polishing module 4A or 4B (i.e., a portion where no residual film is present) and a portion R where the residual film is present have different hues appearing on the image. In an example shown in FIG. 10, the residual film is present in portions R indicated by hatching in the images Pa, Pb, and Pe.

The detection processor 87 is configured to set target regions Ta, Tb, Tc, Td, and Te in the images Pa, Pb, Pc, Pd, and Pe, respectively. In the example shown in FIG. 10, the target regions Ta to Te are ranges surrounded by thick lines. The target regions Ta to Te are set in advance so as to exclude portions other than the substrate W and portions overlapping in images (e.g., the upper bevel portion B1 of the image Pa, the lower bevel portion B2 of the image Pe) from corresponding images. Setting ranges of the target regions Ta to Te are stored in advance in the memory 87a of the detection processor 87.

The target regions are appropriately set in the respective images, so that the multiple images generated by the multiple imaging devices can be made to correspond to different regions of the periphery of the substrate W. In the example shown in FIG. 10, the target region Ta corresponds to the top-edge portion E1 of the substrate W, the target region Tb corresponds to the upper bevel portion B1 of the substrate W, the target region Tc corresponds to the side portion (or the apex) B3 of the substrate W, the target region Td corresponds to the lower bevel portion B2 of the substrate W, and the target region Te corresponds to the bottom-edge portion E2 of the substrate W. Therefore, the detection processor 87 can detect the residual film in each of the multiple regions of the periphery of the substrate W, which are the top-edge portion E1, the upper bevel portion B1, the side portion (or the apex) B3, the lower bevel portion B2, and the bottom-edge portion E2, from the hues appearing in the respective target regions Ta to Te.

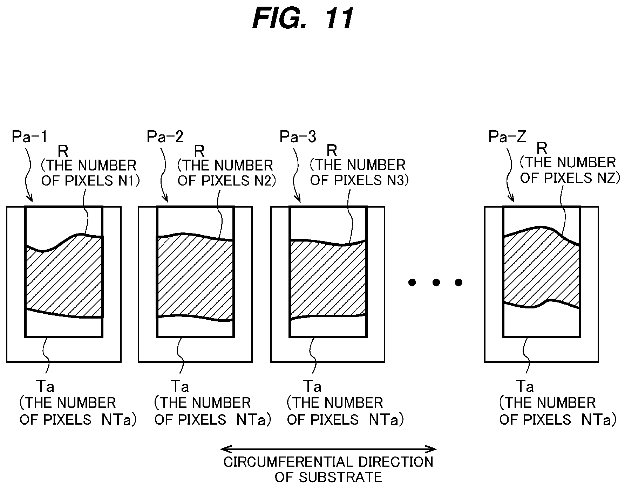

FIG. 11 is a diagram showing an example of an image of the entire circumference of the periphery of the substrate W. Hereinafter, as an example of the image of the entire circumference of the periphery of the substrate W, an image of the entire circumference of the top-edge portion E1 of the substrate W generated by the imaging device 86A will be described, while the same applies to images of entire circumferences of other regions of the periphery of the substrate W generated by the imaging devices 86B to 86E.

In the example shown in FIG. 11, the image of the entire circumference of the top-edge portion E1 of the substrate W is constituted of Z images arranged in the circumferential direction of the substrate W. Images Pa-1 to Pa-Z constitute the image of the entire circumference of the top-edge portion E1 of the substrate W generated by the imaging device 86A. More specifically, the image Pa-1 shown in FIG. 11 is a first image of the top-edge portion E1 of the substrate W generated by the imaging device 86A, an image Pa-2 is a second image of the top-edge portion E1 of the substrate W generated by the imaging device 86A, an image Pa-3 is a third image of the top-edge portion E1 of the substrate W generated by the imaging device 86A, and the image Pa-Z is a Z-th image of the top-edge portion E1 of the substrate W generated by the imaging device 86A. In one embodiment, the detection processor 87 may combine these images to generate a single image.

The detection processor 87 is configured to detect the residual film R from a hue appearing in the target region in the image of the periphery of the substrate W. In the example shown in FIG. 11, the detection processor 87 detects the residual film R from hues appearing in target regions Ta in the images Pa-1 to Pa-Z. Specifically, the detection processor 87 acquires a hue value indicating a hue of each of a plurality of pixels constituting each image. The detection processor 87 compares the hue value of each of the plurality of pixels constituting each image with a predetermined hue reference value, and detects the residual film R. For example, when the hue value of a pixel is larger than the hue reference value, the detection processor 87 detects the residual film R at the pixel. The hue reference value is determined in advance based on experimental results and the like, and is stored in the memory 87a of the detection processor 87.

In this embodiment, the detection processor 87 is configured to calculate an area of the residual film R in the target region from a hue appearing in the target region in the image of the periphery of the substrate W. The area can be represented by the number of pixels. In the example shown in FIG. 11, the detection processor 87 calculates the number of pixels N1 to NZ which are areas of the residual films R present (detected) in the target regions Ta in the images Pa-1 to Pa-Z.

In one embodiment, the detection processor 87 may be configured to determine a thickness of the residual film R in the target region from a hue appearing in the target region in the image of the periphery of the substrate W. A hue on an image changes depending on a thickness of the residual film R. The detection processor 87 may determine the thickness of the residual film R in the target region from the hue appearing in the target region based on correlation data between hue on the image and thickness of the residual film R obtained in advance. In this case, the correlation data between the hue on the image and the thickness of the residual film R is acquired in advance based on experimental results and the like, and is stored in the memory 87a of the detection processor 87.

Further, the detection processor 87 may determine a thickness of the residual film R for each of pixels constituting an image. The detection processor 87 may determine a thickness of the residual film R for each of pixels in a target region in an image, and may calculate an average value of the thicknesses of the residual film R present in the target region.

In another embodiment, the residual-film detector 9 may be a film-thickness measuring device (e.g., an optical film-thickness measuring device) configured to measure a thickness of the residual film present on the periphery of the substrate W. In this case, the residual-film detector 9 directly measures the thickness of the residual film present on the periphery of the substrate W to detect the residual film present on the periphery of the substrate W without generating the image of the periphery of the substrate W by the imaging device.

The residual-film detector 9 of this embodiment is configured to detect the residual film in each of the top-edge portion E1, the upper bevel portion B1, the side portion (or the apex) B3, the lower bevel portion B2, and the bottom-edge portion E2 of the periphery of the substrate W aligned in the thickness direction of the substrate W. Therefore, a detection result of the residual film by the residual-film detector 9 includes detection results of the residual film in each of the top-edge portion E1, the upper bevel portion B1, the side portion B3, the lower bevel portion B2, and the bottom-edge portion E2 of the periphery of the substrate W.

The residual-film detector 9 (specifically, the detection processor 87) is electrically coupled to the controller 20. The detection result of the residual film on the periphery of the substrate W by the residual-film detector 9 (specifically, the detection processor 87) is transmitted to the controller 20. In the example shown in FIG. 11, the number of the pixels N1 to NZ of the residual films R in the target regions Ta in the images Pa-1 to Pa-Z is transmitted to the controller 20 as the detection result of the residual film R of the top-edge portion E1 of the substrate W.

The controller 20 is configured to determine necessity of re-polishing of the periphery of the substrate W based on the detection result of the residual film R by the residual-film detector 9. In this embodiment, the controller 20 determines necessity of re-polishing in each of the top-edge portion E1, the upper bevel portion B1, the side portion (or the apex) B3, the lower bevel portion B2, and the bottom-edge portion E2 of the periphery of the substrate W based on the detection result of the residual film by the residual-film detector 9.

In this embodiment, the controller 20 is configured to determine the necessity of the re-polishing of the periphery of the substrate W based on a residual-film ratio which is a ratio of the area of the residual film R in the target region in each image to an entire area of the target region. For example, the controller 20 determines the necessity of the re-polishing based on a residual-film ratio which is a ratio of the number of the pixels in which the residual film R is present in each image to the total number of pixels of the target regions.

In the example shown in FIG. 11, the residual-film ratio is expressed by the following formula (1)$Residual - film ratio = \left(N1+N2+N3+…+NZ\right) / \left(NTa\times Z\right)$ where, N1 is the number of the pixels of the residual film R in the target region Ta of the image Pa-1, N2 is the number of the pixels of the residual film R in the target region Ta of the image Pa-2, N3 is the number of the pixels of the residual film R in the target region Ta of the image Pa-3, NZ is the number of the pixels of the residual film R in the target region Ta of the image Pa-Z, NTa is the number of the pixels of the target region Ta, and Z is the number of the images. The number of the pixels NTa of the target region Ta may be transmitted from the detection processor 87 to the controller 20 together with the detection result of the residual film, or may be stored in advance in the memory 20a of the controller 20.

The controller 20 calculates the residual-film ratio of the periphery of the substrate W, and determines the necessity of the re-polishing of the periphery of the substrate W based on the residual-film ratio. For example, the controller 20 calculates the residual-film ratio of the periphery of the substrate W, and determines that the re-polishing of the periphery of the substrate W is necessary when the residual-film ratio is larger than a residual-film ratio threshold value. In the example shown in FIG. 11, the controller 20 determines the necessity of the re-polishing of the top-edge portion E1 of the substrate W based on the residual-film ratio of the top-edge portion E1 of the substrate W calculated by the above formula (1).

In one embodiment, the controller 20 may determine the necessity of the re-polishing of the periphery of the substrate W based on a thickness of the residual film R present on the periphery of the substrate W. For example, the controller 20 determines that the re-polishing of the periphery of the substrate W is necessary when the thickness of the residual film R present on the periphery of the substrate W is larger than a film thickness threshold value. In this case, an average value of thicknesses of the residual films R present in the target regions of the images may be used as the thickness of the residual film R present on the periphery of the substrate W.

The controller 20 is configured to determine a polishing condition for the re-polishing of the periphery of the substrate W when determining that the re-polishing of the periphery of the substrate W is necessary. Specifically, the controller 20 is configured to determine a polishing time as the polishing condition for the re-polishing of the periphery of the substrate W based on the residual-film ratio of the periphery of the substrate W and correlation data between residual-film ratio and polishing time. The correlation data between the residual-film ratio and the polishing time is acquired in advance based on experimental results and the like, and is stored in the memory 20a of the controller 20. The correlation data between the residual-film ratio and the polishing time is data showing a relationship in which, as the residual-film ratio of the periphery of the substrate W is larger, the polishing time required for the re-polishing of the periphery of the substrate W is longer.

In one embodiment, the controller 20 may be configured to determine the polishing time as the polishing condition for the re-polishing of the periphery of the substrate W based on the thickness of the residual film R present on the periphery of the substrate W. In this case, the controller 20 is configured to determine the polishing time as the polishing condition for the re-polishing of the periphery of the substrate W based on the thickness of the residual film R present on the periphery of the substrate W and correlation data between thickness of the residual film R and polishing time. The correlation data between the thickness of the residual film R and the polishing time is acquired in advance based on experimental results and the like, and is stored in the memory 20a of the controller 20. The correlation data between the thickness of the residual film R and the polishing time is data showing a relationship in which, as the thickness of the residual film R of the periphery of the substrate W is larger, the polishing time required for the re-polishing of the periphery of the substrate W is longer.

In one embodiment, the controller 20 may be configured to determine the polishing time based on a combination of the residual-film ratio of the periphery of the substrate W and the thickness of the residual film R present on the periphery of the substrate W.

Further, the controller 20 is configured to determine, as the polishing condition for the re-polishing, a polishing angle corresponding to a region of the periphery of the substrate W determined to require the re-polishing. The polishing angle is a tilt angle of the polishing head 30A, 30B, 30C, or 30D. For example, when the controller 20 determines that re-polishing of the top-edge portion E1 of the substrate W is necessary, the controller 20 determines a polishing angle corresponding to the top-edge portion E1 as the polishing condition for the re-polishing of the periphery of the substrate W.

The polishing module 4A or the polishing module 4B of the polishing section 4 re-polishes the periphery of the substrate W under the determined polishing condition. Specifically, the polishing module 4A or the polishing module 4B re-polishes the periphery of the substrate W by at least one of the polishing heads 30A to 30D for the determined polishing time and at the determined polishing angle. For example, the controller 20 instructs the polishing-head tilting mechanism 70A of the polishing module 4A to tilt the polishing head 30A to the determined polishing angle, and instructs the air cylinder 35 of the polishing head 30A to press the polishing tape 22A against the periphery of the substrate W with the pressing member 32 for the determined polishing time. In this manner, the polishing module 4A re-polishes the region of the periphery of the substrate W determined to require the re-polishing under the determined polishing condition (the polishing time and the polishing angle).

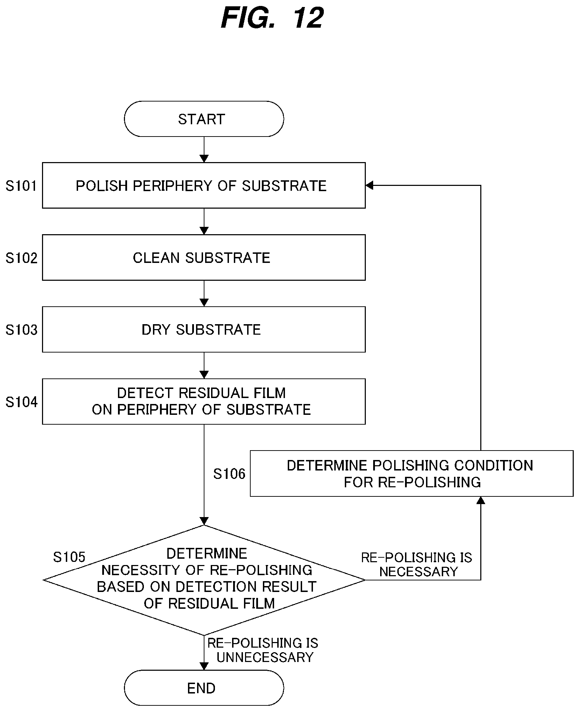

FIG. 12 is a flowchart showing an embodiment of a substrate processing method. A processing flow described below is performed by the above-described substrate processing apparatus.

In a step S101, at least one of the polishing module 4A and the polishing module 4B of the polishing section 4 polishes the periphery of the substrate W according to a predetermined polishing recipe.

In a step S102, the cleaning section 6 cleans the substrate W polished by at least one of the polishing module 4A and the polishing module 4B.

In a step S103, the drying section 7 dries the substrate W cleaned by the cleaning section 6.

In a step S104, the residual-film detector 9 detects the residual film on the periphery of the substrate W. In one embodiment, the imaging devices 86A to 86E of the residual-film detector 9 generate the images of the periphery of the substrate W. The detection processor 87 of the residual-film detector 9 detects the residual film from a hue appearing on the images of the periphery of the substrate W. For example, the detection processor 87 may detect the residual film in the target regions in the images of the periphery of the substrate W and calculate an area of the residual film.

In a step S105, the controller 20 determines necessity of re-polishing of the periphery of the substrate W based on the detection result of the residual film by the residual-film detector 9. In one embodiment, the controller 20 determines the necessity of the re-polishing of the periphery of the substrate W based on a residual-film ratio which is a ratio of the area of the residual film R in the target regions in the images to an entire area of the target regions.

The controller 20 determines a polishing condition for the re-polishing when determining that the re-polishing of the periphery of the substrate W is necessary in the step S105 (step S106). In one embodiment, the controller 20 determines, as the polishing condition for the re-polishing, a polishing time of the periphery of the substrate W based on the residual-film ratio of the periphery of the substrate W and the correlation data between residual-film ratio and polishing time. Further, the controller 20 determines, as the polishing condition for the re-polishing, a polishing angle corresponding to a region of the periphery of the substrate W determined to require the re-polishing.

The polishing module 4A or the polishing module 4B of the polishing section 4 re-polishes the periphery of the substrate W under the polishing condition for the re-polishing determined in the step S106 (the processing flow returns to the step S101). Specifically, the polishing module 4A or the polishing module 4B re-polishes the periphery of the substrate W by at least one of the polishing heads 30A to 30D for the determined polishing time and at the determined polishing angle. The steps S102 to S105 are then performed again. The processing flow repeats the steps S101 to S106 until the controller 20 determines in the step S105 that the re-polishing of the periphery of the substrate W is unnecessary.

The controller 20 terminates the processing when determining that the re-polishing of the periphery of the substrate W is unnecessary in the step S105. Specifically, the controller 20 instructs the first transfer robot 14 to return the substrate W from the residual-film detector 9 to the substrate cassette 19 of the load port 2.

According to this embodiment, the controller 20 can appropriately determine the polishing condition for the re-polishing based on a state of the residual film on the periphery of the substrate W.

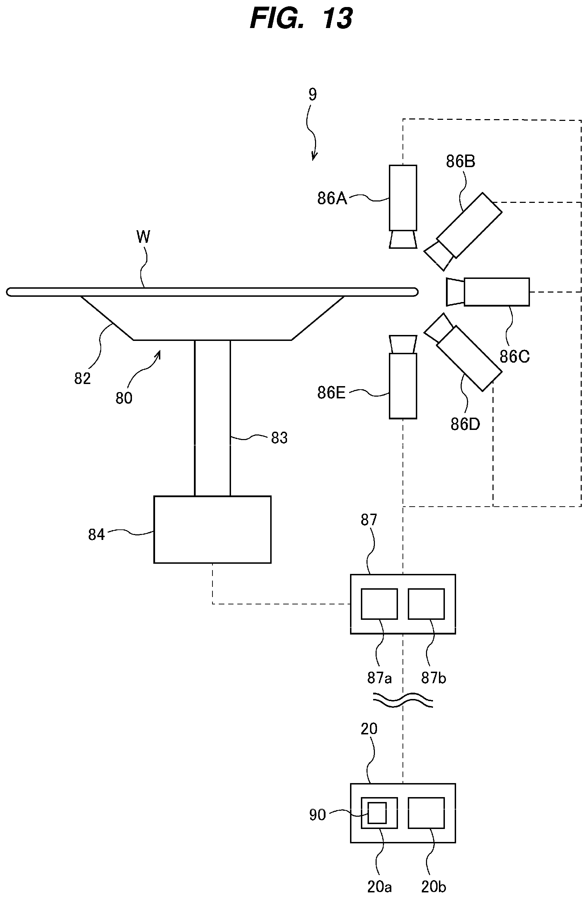

In one embodiment, as shown in FIG. 13, the controller 20 may have a polishing-condition determination model 90 constructed by machine learning, and may be configured to output the polishing condition for the re-polishing of the periphery of the substrate W from the polishing-condition determination model 90. FIG. 13 is a schematic diagram showing an embodiment of the controller 20 having the polishing-condition determination model 90 and the residual-film detector 9. The controller 20 of this embodiment has the polishing-condition determination model 90 stored in the memory 20a. The polishing-condition determination model 90 is a trained model constructed by machine learning. Examples of the machine learning include an SVR method (support vector regression method), a PLS method (partial least squares method), a deep learning method, a random forest method, and a decision tree method. In one example, the polishing-condition determination model 90 is constituted of a neural network constructed by the deep learning method.

Training data for use in the machine learning for the polishing-condition determination model 90 includes an image of a periphery of a substrate and a polishing condition (i.e., a polishing time and a polishing angle) required to remove a residual film appearing on the image by polishing of the substrate. The image of the periphery of the substrate is an explanatory variable, and the polishing condition (i.e., the polishing time and the polishing angle) is an objective variable. The polishing condition contained in the training data is a correct label, and is obtained from a result of actual polishing of the substrate.

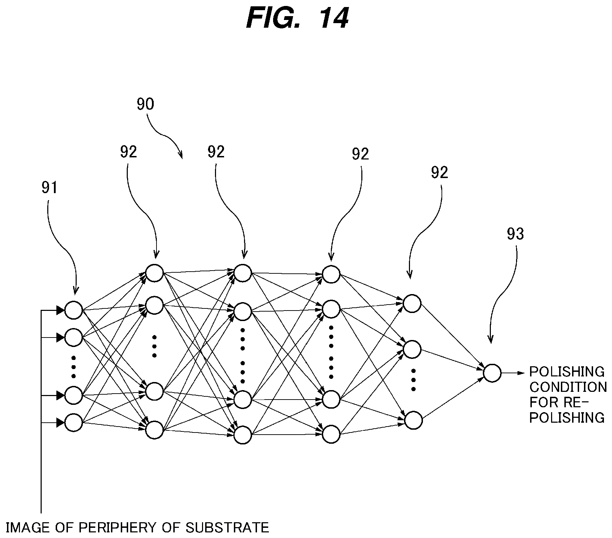

FIG. 14 is a schematic diagram showing an example of the polishing-condition determination model 90 constructed using the deep learning method. The polishing-condition determination model 90 has an input layer 91, multiple hidden layers (also referred to as intermediate layers) 92, and an output layer 93. The polishing-condition determination model 90 shown in FIG. 14 has four hidden layers 92, while the configuration of the polishing-condition determination model 90 is not limited to the embodiment shown in FIG. 14.

The polishing-condition determination model 90 is configured such that when the image of the periphery of the substrate is inputted into the input layer 91, a polishing condition for re-polishing of the periphery of the substrate (i.e., the polishing time and the polishing angle) is outputted from the output layer 93. Construction of the polishing-condition determination model 90 using the deep learning is performed as follows. The image of the periphery of the substrate is inputted into the input layer 91 shown in FIG. 14. The controller 20 compares the polishing condition for the re-polishing of the periphery of the substrate outputted from the output layer 93 with the polishing condition (i.e., the correct label) corresponding to the image of the periphery of the substrate contained in the training data, and adjusts parameters (such as weights and thresholds) of each node (i.e., neuron) so as to minimize an error. Thus, the polishing-condition determination model 90 is trained so as to output an appropriate polishing condition for the re-polishing of the periphery of the substrate from the output layer 93 based on the image of the periphery of the substrate inputted into the input layer 91.

The polishing-condition determination model 90 is constructed by repeating the above-described learning using images of peripheries of multiple substrates. The polishing-condition determination model 90 constructed by the machine learning may basically have a low prediction accuracy for input data that has not been learned. Therefore, a large number of images in which residual films appear in different manners are used for the machine learning, so that an accuracy of the polishing condition for the re-polishing of the periphery of the substrate outputted from the polishing-condition determination model 90 can be improved.

Determination of the polishing condition for the re-polishing of the periphery of the substrate W using the polishing-condition determination model 90 is performed as follows. The controller 20 inputs images of the periphery of the substrate W generated by the imaging devices 86A to 86E of the residual-film detector 9 into the input layer 91 of the polishing-condition determination model 90. In this embodiment, the detection result of the residual film on the periphery of the substrate W by the residual-film detector 9 is an image of the target region set in advance. The controller 20 performs an arithmetic operation according to an algorithm defined by the polishing-condition determination model 90. The controller 20 outputs the polishing condition for the re-polishing of the periphery of the substrate W from the output layer 93 of the polishing-condition determination model 90 to determine the polishing condition for the re-polishing of the periphery of the substrate W.

In one embodiment, the controller 20 may output an estimated value of the thickness of the residual film from the polishing-condition determination model 90 in addition to the polishing condition for the periphery of the substrate W. In this case, the correct label for use in the training data includes an actually measured value of the thickness of the residual film on the periphery of the substrate and the polishing condition (i.e., the polishing time and the polishing angle) required to remove the residual film appearing on the image by polishing of the substrate.

In one embodiment, after re-polishing the periphery of the substrate W under the polishing condition determined using the polishing-condition determination model 90, the residual-film detector 9 may detect the residual film on the periphery of the substrate W again. In this case, the polishing-condition determination model 90 may be updated by performing machine learning using an image of the periphery of the substrate W before the re-polishing and a detection result of the residual film after the re-polishing as training data.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a substrate processing apparatus and a substrate processing method for polishing a substrate, such as a wafer.

### Reference Signs List

1 housing
2 load port
4 polishing section
4A, 4B polishing module
6 cleaning section
7 drying section
9 residual-film detector
11 first temporary station
12 second temporary station
14 first transfer robot
15 second transfer robot
16 third transfer robot
17 fourth transfer robot
19 substrate cassette
20 controller
20a memory
20b arithmetic device
22A, 22B, 22C, 22D polishing tape
25 substrate holder
27 holding stage
28 shaft
29 holding-stage driving mechanism
30A, 30B, 30C, and 30D polishing head
32 pressing member
35 air cylinder (actuator)
36 tape advancing mechanism
38 polishing-head supporting member
40A, 40B, 40C, 40D polishing-tape feeding mechanism
41 tape feeding reel
42 tape take-up reel
44, 45, 46, 47 guide roller
48 reel base
51 lower supply nozzle
52 upper supply nozzle
60 polishing-head translation mechanism
61 movable plate
63 coupling member
64 guide rail
66 coupling shaft
67 air cylinder (actuator)
68 base plate
70A, 70B, 70C, and 70D polishing-head tilting mechanism
72 crank arm
73 arm rotating device
80 substrate holding device
82 holding stage
83 shaft
84 holding-stage rotating mechanism
86A, 86B, 86C, 86D, 86E imaging device
87 detection processor
87a memory
87b arithmetic device
90 polishing-condition determination model
91 input layer
92 hidden layer (intermediate layer)
93 output layer

## Claims

1. A substrate processing apparatus comprising:
a polishing section configured to polish a periphery of a substrate;
a residual-film detector configured to detect a residual film on the periphery of the substrate polished by the polishing section; and
a controller configured to determine necessity of re-polishing of the periphery of the substrate based on a detection result of the residual film by the residual-film detector, and determine a polishing condition for the re-polishing based on the detection result of the residual film when determining that the re-polishing is necessary,
wherein the polishing section is configured to re-polish the periphery of the substrate under the determined polishing condition.

2. The substrate processing apparatus according to claim 1, wherein the residual-film detector includes:
an imaging device configured to generate an image of the periphery of the substrate; and
a detection processor configured to detect the residual film on the periphery of the substrate based on the image.

3. The substrate processing apparatus according to claim 2, wherein
the residual-film detector further includes a substrate holding device configured to hold the substrate and rotate the substrate, and
the image is an image of an entire circumference of the periphery of the substrate.

4. The substrate processing apparatus according to claim 2, wherein
the detection processor is configured to calculate an area of the residual film from a hue appearing on the image, and
the controller is configured to determine the necessity of the re-polishing of the periphery of the substrate based on a residual-film ratio which is a ratio of the area of the residual film in a target region in the image to an entire area of the target region.

5. The substrate processing apparatus according to claim 4, wherein the controller is configured to determine a polishing time as the polishing condition based on the residual-film ratio and correlation data between residual-film ratio and polishing time.

6. The substrate processing apparatus according to claim 1, wherein
the residual-film detector is configured to detect the residual film in each of multiple regions of the periphery aligned in a thickness direction of the substrate,
the controller is configured to:
determine necessity of re-polishing in each of the multiple regions based on the detection result of the residual film; and
determine, as the polishing condition for the re-polishing, a polishing angle corresponding to a region determined to require the re-polishing, and
the multiple regions are regions polished by the polishing section at different polishing angles.

7. The substrate processing apparatus according to claim 6, wherein the residual-film detector includes:
multiple imaging devices respectively configured to generate images of the multiple regions; and
a detection processor configured to detect the residual film in each of the multiple regions based on the images of the multiple regions.

8. The substrate processing apparatus according to claim 1, wherein
the residual-film detector includes:
an imaging device configured to generate an image of the periphery of the substrate; and
a detection processor configured to detect the residual film on the periphery of the substrate based on the image, and
the controller has a polishing-condition determination model constructed by machine learning, and is configured to input the image into the polishing-condition determination model and output the polishing condition for the re-polishing from the polishing-condition determination model.

9. A substrate processing method comprising:
detecting a residual film on a periphery of a substrate polished by a polishing section;
determining necessity of re-polishing of the periphery of the substrate based on a detection result of the residual film;
determining a polishing condition for the re-polishing based on the detection result of the residual film when determining that the re-polishing is necessary; and
re-polishing the periphery of the substrate by the polishing section under the determined polishing condition.

10. The substrate processing method according to claim 9, wherein detecting the residual film on the periphery of the substrate comprises generating an image of the periphery of the substrate by an imaging device, and detecting the residual film on the periphery of the substrate based on the image.

11. The substrate processing method according to claim 10, wherein generating the image of the periphery of the substrate comprises generating an image of an entire circumference of the periphery of the substrate while the substrate is rotated by a substrate holding device.

12. The substrate processing method according to claim 10, wherein
detecting the residual film on the periphery of the substrate comprises calculating an area of the residual film from a hue appearing on the image, and
determining the necessity of the re-polishing of the periphery of the substrate comprises determining the necessity of the re-polishing of the periphery of the substrate based on a residual-film ratio which is a ratio of the area of the residual film in a target region in the image to an entire area of the target region.

13. The substrate processing method according to claim 12, wherein determining the polishing condition for the re-polishing comprises determining a polishing time as the polishing condition based on the residual-film ratio and correlation data between residual-film ratio and polishing time.

14. The substrate processing method according to claim 9, wherein
detecting the residual film on the periphery of the substrate comprises detecting the residual film in each of multiple regions of the periphery aligned in a thickness direction of the substrate,
determining the necessity of the re-polishing of the periphery of the substrate comprises determining necessity of re-polishing in each of the multiple regions based on the detection result of the residual film,
determining the polishing condition for the re-polishing includes determining, as the polishing condition for the re-polishing, a polishing angle corresponding to a region determined to require the re-polishing, and
the multiple regions are regions polished by the polishing section at different polishing angles.

15. The substrate processing method according to claim 9, wherein
detecting the residual film on the periphery of the substrate comprises generating an image of the periphery of the substrate by an imaging device, and detecting the residual film on the periphery of the substrate based on the image, and
determining the polishing condition for the re-polishing comprises inputting the image into a polishing-condition determination model constructed by machine learning, and outputting the polishing condition for the re-polishing from the polishing-condition determination model.
